# DEMANDE DE BREVET EUROPEEN

(11) **EP 3 720 252 A1**
(43) Date de publication de la demande: **07.10.2020**
(21) Numéro de dépôt: 20168020.4
(22) Date de dépôt: 03.04.2020
(51) Int. Cl.: H05B 45/37, G01S 7/484, G01S 17/89

(54) **ALIMENTATION ÉLECTRIQUE D'ÉCLAIRAGE DE CAMÉRA**

(30) Priorité: 05.04.2019 FR 1903663
(71) Demandeur: Aptiv Technologies Limited, St. Michael (BB)
(72) Inventeur: MAJERCZAK, Roman, 34-460 Szczawnica (PL); BARSZCZOWSKI, Maciej, 43-300 BIELSKO-BIALA (PL)
(74) Mandataire: Vigand, Philippe

(57) **Abrégé**

Un système d'alimentation électrique pulsée (40) pour un dispositif d'éclairage (80) de capteur de vision (10) de véhicule (20) comporte un générateur d'alimentation électrique pulsée (70) configurée pour alimenter électriquement le dispositif d'éclairage (80); un régulateur linéaire de tension électrique continu (55) configuré pour délivrer une tension électrique stabilisée au générateur d'alimentation électrique pulsée (70) depuis une source d'alimentation électrique variable (30); un amplificateur (50) du courant électrique délivré par le régulateur linéaire de tension électrique continu (55) au générateur d'alimentation électrique pulsée (70), l'amplificateur (50) du courant électrique étant configuré pour délivrer un courant électrique amplifié au générateur d'alimentation électrique pulsée (70).

## Description

### Domaine technique

La présente invention concerne l'alimentation électrique de l'éclairage d'une caméra, plus particulièrement d'un système d'alimentation électrique pulsée pour un dispositif d'éclairage de capteur de vision pour un système d'aide à la conduite d'un véhicule.

### Etat de la technique

Les véhicules équipés de système d'aide à la conduite comportent généralement des capteurs de visions, tels que des caméras, permettant une vision nocturne d'obstacles ou encore d'indications routières telles que des panneaux indicateurs de limitation de vitesse. Il est important de pouvoir détecter correctement ces différents éléments, même en cas de visibilité réduite de sorte à pouvoir déclencher, en cas de nécessité, des dispositifs d'aide à la conduite.

Généralement, les caméras embarqués comportent des dispositifs d'éclairage faisant partie de la caméra, tels que des éclairages de type infra-rouge. L'alimentation électrique de ce type d'éclairage comprend généralement une alimentation à découpage de type convertisseur DC/DC permettant de stabiliser l'éclairage tout en lui fournissant suffisamment de puissance pour alimenter les diodes électroluminescente infra-rouge de puissance éclairant la zone sous contrôle de la caméra.

Ce type d'alimentation peut engendrer des distorsions d'images capturées par la caméra, le circuit électronique de capteur d'image étant généralement sensible aux émissions électromagnétiques de l'alimentation à découpage. De plus, ce type d'alimentation est volumineux, ce qui rend difficile la miniaturisation de ce type de caméra à vision nocturne.

Il est donc important de proposer une solution nouvelle résolvant ce problème.

### Résumé de l'invention

Selon l'invention, un système d'alimentation électrique pulsée pour un dispositif d'éclairage de capteur de vision de véhicule comporte un générateur d'alimentation électrique pulsée configurée pour alimenter électriquement le dispositif d'éclairage, un régulateur linéaire de tension électrique continu configuré pour délivrer une tension électrique stabilisée au générateur d'alimentation électrique pulsée depuis une source d'alimentation électrique variable et un amplificateur du courant électrique délivré par le régulateur linéaire de tension électrique au générateur d'alimentation électrique puisée, l'amplificateur du courant électrique étant configuré pour délivrer un courant électrique amplifié au générateur d'alimentation électrique puisée.

De plus, le système peut comporter une unité de diagnostic du dispositif d'éclairage comprenant un dispositif de mesure du courant électrique amplifié moyen et un dispositif de comparaison du courant électrique amplifié moyen avec un seuil de courant maximal prédéterminé de sorte à pouvoir détecter un défaut de surconsommation du dispositif d'éclairage. Le système peut également comporter un dispositif de coupure d'alimentation électrique du générateur d'alimentation électrique pulsé configuré pour couper l'alimentation électrique du générateur d'alimentation électrique pulsé si le courant électrique amplifié moyen est supérieur au seuil de courant maximal prédéterminé.

L'amplificateur du courant électrique peut comprendre un premier transistor bipolaire agencé selon une topologie Darlington avec un second transistor bipolaire, le dit second transistor bipolaire étant un transistor bipolaire du régulateur linéaire de tension électrique continu. Le premier transistor bipolaire peut comporter une caractéristique de courant maximal de collecteur d'au moins 4 ampères, de préférence 6 ampères. Le premier et le second transistors bipolaires peuvent comporter une fréquence de coupure allant de 100 Hz à 100 Mhz, de préférence d'au moins 100 MHz.

Selon l'invention, un capteur de vision de véhicule comprend le système d'alimentation électrique pulsée décrit ci-dessus. Le capteur de vision peut-être une caméra comportant le système d'éclairage, le système d'éclairage comportant une pluralité de diodes électroluminescentes infra-rouge de sorte que le capteur de vision de véhicule est une caméra à éclairage infra-rouge. Le système d'alimentation électrique pulsée peut être configuré pour fournir un courant pulsé jusqu'à 100 MHz aux diodes électroluminescentes infra-rouge.

D'autres buts et avantages de la présente invention apparaîtront au vu de la description qui suit.

### Brève description des dessins

D'autres caractéristiques, buts et avantages de l'invention apparaîtront à la lecture de la description détaillée qui va suivre, et en regard des dessins annexés, donnés à titre d'exemple non limitatif et sur lesquels:

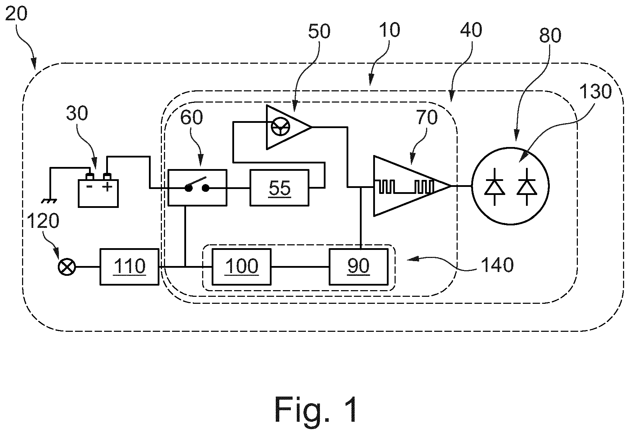

[Fig.1] représente un bloc diagramme schématique du système d'alimentation électrique pulsée du dispositif d'éclairage d'une caméra embarquée dans un véhicule selon l'invention.

### Description détaillée

Selon la figure 1, un véhicule 20 est équipé d'une caméra 10 ou capteur de vision, permettant une assistance à la conduite du véhicule 20. La caméra 10 est alimentée électriquement par la batterie 30 du véhicule 10. La caméra 10 comprend un dispositif d'éclairage 80 permettant notamment de capturer des images dans des conditions insuffisantes de lumière, tel que durant la nuit, ou encore lors de la traversée de tunnel par le véhicule 20. De préférence, le dispositif d'éclairage 80 comporte une pluralité de diodes électroluminescentes 130 de type infra-rouge.

Afin de limiter la consommation électrique du dispositif, la caméra 10 comporte un système d'alimentation électrique pulsée 40 fournissant un courant électrique pendant une durée suffisante permettant à la pluralité de diodes électroluminescentes 130 de type infra-rouge l'éclairage de la zone à illuminer, c'est-à-dire les panneaux indicateur de limite de vitesse, ou encore des obstacles sur le trajet du véhicule 20, et permettant au circuit électronique capteur d'image (non représenté) de la caméra 10 de capturer les images nécessaire à l'analyse de la zone observée par la caméra 10.

Le système d'alimentation électrique pulsée 40 pour le dispositif d'éclairage 80 de la caméra 10 du véhicule 20 comporte un générateur d'alimentation électrique pulsée 70 configuré pour alimenter électriquement le dispositif d'éclairage 80.

Afin de pouvoir notamment alimenter électriquement le dispositif d'éclairage 80 comportant une pluralité de diodes électroluminescentes 130 de type infra-rouge, le générateur d'alimentation électrique pulsée 70 doit être capable de fournir au moins 4 ampères, de préférence 6 ampères, voir 10 ampères en courant de pic. Le générateur d'alimentation électrique pulsée 70 doit également être capable de pouvoir pulser l'alimentation jusqu'à une centaine de Mégahertz, notamment dans le cas d'application de caméras 10 à mesure de temps de propagation de la lumière infra-rouge, communément appelées selon leur désignation anglophone par 'Time Of Flight Camera' ou caméra temps de vol'. Pour des applications de types surveillance du conducteur par caméra, une fréquence de l'ordre d'une centaine de mégahertz est suffisante pour pulser l'alimentation électrique du dispositif d'éclairage 80 de type infra-rouge.

Afin de fournir une tension électrique stabilisée au générateur d'alimentation électrique pulsée 70, le système d'alimentation électrique pulsée 40 comporte un régulateur linéaire de tension électrique continu 55 configuré pour délivrer une tension électrique stabilisée au générateur d'alimentation électrique pulsée 70 depuis une source d'alimentation électrique variable, en l'occurrence, depuis la batterie 30 du véhicule 20.

L'utilisation d'un régulateur linéaire de tension électrique continu 55 au lieu d'une alimentation à découpage bien connu de l'art antérieur des caméras infra-rouge, permet notamment de s'affranchir des problème d'émissions électromagnétiques pouvant créer de la distorsion d'images capturés par la caméra. De préférence, le régulateur de tension électrique continu 55 est un régulateur linéaire de tension électrique série, c'est à dire comportant un transistor fournissant le courant électrique au générateur d'alimentation électrique pulsée 70.

Afin de pouvoir fournir suffisamment de courant électrique au générateur d'alimentation électrique pulsée 70, le système d'alimentation électrique pulsée 40 comporte un amplificateur 50 du courant électrique délivré par le régulateur linéaire de tension électrique continu 55 au générateur d'alimentation électrique pulsée 70, l'amplificateur 50 du courant électrique étant configuré pour délivrer un courant électrique amplifié au générateur d'alimentation électrique pulsée 70. De préférence, l'amplificateur 50 du courant électrique comprend un premier transistor bipolaire agencé selon une topologie Darlington avec un second transistor bipolaire, le dit second transistor bipolaire étant un transistor bipolaire du régulateur linéaire de tension électrique continu de type série.

Afin de pouvoir correctement fournir le courant électrique au générateur d'alimentation électrique pulsée 70, le dit générateur d'alimentation électrique pulsée 70 pouvant entrainer des appels de courant d'au moins quatre ampères selon une fréquence d'une centaine de Mégahertz, le premier transistor bipolaire et le second transistor bipolaire comprennent une fréquence de coupure d'au moins 100 MHz.

Afin de pouvoir diagnostiquer un défaut du dispositif d'éclairage 80, le système d'alimentation électrique pulsée 40 comprend une unité de diagnostic 140 du dispositif d'éclairage 80 comprenant un dispositif de mesure du courant électrique amplifié moyen 90 permettant de mesurer la valeur moyenne du courant électrique pulsé consommé par le générateur d'alimentation électrique pulsée 70, et un dispositif de comparaison 100 du courant électrique amplifié moyen avec un seuil de courant maximal prédéterminé de sorte à pouvoir détecter un défaut de surconsommation du dispositif d'éclairage 80.

De préférence, le dispositif de mesure du courant électrique amplifié moyen 90 comporte une structure de mesure du courant fourni au générateur d'alimentation électrique pulsée 70 selon une topologie de type miroir de courant. L'image du courant fourni au générateur d'alimentation électrique pulsée 70 circulant dans le miroir de courant est moyennée par le biais d'un circuit électrique de topologie résistance et condensateur série dont le condensateur est relié à la masse électrique du dispositif.

Le dispositif de comparaison 100 du courant électrique amplifié moyen permet de couper ou d'autoriser l'alimentation du dispositif d'éclairage 80 désactivant ou en activant le régulateur de tension électrique continu 55 par le biais d'un bloc interrupteur électrique 60. De préférence, le régulateur de tension électrique continu 55 comprend une broche d'activation ou de désactivation de la régulation de tension de sorte qu'il n'est pas nécessaire de prévoir un bloc supplémentaire de type interrupteur électrique 60.

L'unité de diagnostic 140 du dispositif d'éclairage 80 est également reliée électriquement à une unité de contrôle 110 externe à la camera 10 permettant notamment, par le biais d'un voyant 120 ou autre interface visuel, d'informer un utilisateur du véhicule 20 de la défaillance du dispositif d'éclairage 80 de la caméra 10.

## Revendications

1. Système d'alimentation électrique pulsée (40) pour un dispositif d'éclairage (80) de capteur de vision (10) de véhicule (20) comportant :
- un générateur d'alimentation électrique pulsée (70) configurée pour alimenter électriquement le dispositif d'éclairage (80);
- un régulateur linéaire de tension électrique continu (55) configuré pour délivrer une tension électrique stabilisée au générateur d'alimentation électrique pulsée (70) depuis une source d'alimentation électrique variable (30);
- un amplificateur (50) du courant électrique délivré par le régulateur linéaire de tension électrique continu (55) au générateur d'alimentation électrique pulsée (70), l'amplificateur (50) du courant électrique étant configuré pour délivrer un courant électrique amplifié au générateur d'alimentation électrique pulsée (70).

2. Système (40) selon la revendication 1 **caractérisé en ce qu'**il comporte une unité de diagnostic (140) du dispositif d'éclairage (80) comprenant :
- un dispositif de mesure du courant électrique amplifié moyen (90);
- un dispositif de comparaison (100) du courant électrique amplifié moyen avec un seuil de courant maximal prédéterminé de sorte à pouvoir détecter un défaut de surconsommation du dispositif d'éclairage (80).

3. Système (40) selon la revendication 2 **caractérisé en ce qu'**il comporte un dispositif de coupure d'alimentation électrique (60) du générateur d'alimentation électrique pulsé (70) configuré pour couper l'alimentation électrique du générateur d'alimentation électrique pulsé (70) lorsque le courant électrique amplifié moyen est supérieur au seuil de courant maximal prédéterminé.

4. Système (40) selon l'une quelconque des revendications précédentes **caractérisé en ce que** l'amplificateur (100) du courant électrique comprend un premier transistor bipolaire agencé selon une topologie Darlington avec un second transistor bipolaire, le dit second transistor bipolaire étant un transistor bipolaire du régulateur linéaire de tension électrique continu (55).

5. Système (40) selon la revendication précédente **caractérisé en ce que** le premier transistor bipolaire comporte une caractéristique de courant maximal de collecteur d'au moins 4 ampères.

6. Système (40) selon l'une quelconque des revendications 4 et 5 **caractérisé en ce que** le premier et le second transistors bipolaires comportent une fréquence de coupure d'au moins 100 MHz.

7. Capteur de vision (10) de véhicule (20) comprenant le système d'alimentation électrique pulsée (40) selon l'une quelconque des revendications précédentes.

8. Capteur (10) selon la revendication précédente, **caractérisé en ce qu'**il comporte le système d'éclairage (80).

9. Capteur (10) selon la revendication précédente **caractérisé en ce que** le système d'éclairage (80) comporte une pluralité de diodes électroluminescentes infra-rouge (130).

10. Capteur (10) selon la revendication précédentes **caractérisé en ce que** le système d'alimentation électrique pulsée (40) est configuré pour fournir un courant pulsé jusqu'à 100 MHz aux diodes électroluminescentes infra-rouge (130).
